# EUROPEAN PATENT APPLICATION

(11) **EP 4 608 063 A1**
(43) Date of publication of application: **27.08.2025**
(21) Application number: 22962723.7
(22) Date of filing: 19.10.2022
(51) Int. Cl.: H04W 84/10, A24F 40/65, H04W 4/38

(54) **COVER MEMBER**

(71) Applicant: Japan Tobacco Inc., Tokyo 105-6927 (JP)
(72) Inventor: FUJIKI, Takashi, Tokyo 130-8603 (JP); YOSHIDA, Ryo, Tokyo 130-8603 (JP)
(74) Representative: Hoffmann Eitle
(86) International application number: PCT/JP2022/038867
(87) International publication number: WO 2024/084611

(57) **Abstract**

A cover member which is detachable from an electronic device operated by means of a first battery is provided with: a first communication unit capable of communicating with an external terminal; a second communication unit for acquiring information relating to the electronic device from said electronic device; and a control unit for controlling communication of the first communication unit and the second communication unit on the basis of the information relating to the electronic device acquired through the second communication unit.

## Description

### [Technical Field]

The present disclosure relates to a cover member.

### [Background Art]

Many portable electronic devices run on a battery built into a main body. Electronic devices may contain electronic components that consume a large amount of power, in addition to electronic components that consume a small amount of power.

### [Citation List]

### [Patent Literature]

[PTL 1] JP 2006-129262 A

### [Summary of Invention]

### [Technical Problem]

When an electronic component that consumes a large amount of power is operating, the battery may approach the maximum value of power that can be supplied thereby. In this case, priority is given to operation of the electronic component that consumes a large amount of power, while operation of other electronic components is restricted. Communication with an external terminal is restricted, for example.

In light of this problem, the present disclosure provides technology for achieving continuous external communication, even if a communication function of an electronic device is restricted.

### [Solution to Problem]

One embodiment of the present disclosure provides a cover member which is detachable from an electronic device operated by means of a first battery, the cover member comprising: a first communication unit capable of communicating with an external terminal; a second communication unit for acquiring information relating to the electronic device from said electronic device; and a control unit for controlling communication of the first communication unit and the second communication unit on the basis of the information relating to the electronic device acquired through the second communication unit.

During a period in which communication between the electronic device and the external terminal is restricted, the first communication unit may send the information acquired from the electronic device to the external terminal.

The period in which communication is restricted may be a period in which power supplied by the first battery is close to an upper limit value.

The first communication unit may send to the external terminal information indicating a state of operation of the electronic device.

The cover member may comprise a second battery which is charged by means of electrical supply from the electronic device during charging thereof.

When the electronic device is an aerosol generating device comprising a heating unit for heating an aerosol source, the first communication unit may send information previously acquired from the aerosol generating device to the external terminal while the aerosol source is being heated by means of the heating unit.

When the electronic device is an aerosol generating device comprising a heating unit for heating an aerosol source, a main body portion may cover part of the surface of the aerosol generating device.

When the electronic device is an aerosol generating device comprising a heating unit for heating an aerosol source, attachment of a main body portion to the aerosol generating device may constitute one condition enabling heating of the aerosol source by means of the heating unit.

A switch on the electronic device side may be operable as a result of pressing by a user while a main body portion is attached to the electronic device.

The cover member may be provided with an operation unit for receiving user operations and notifying same to the electronic device.

A main body portion attached to the electronic device may form an integral external appearance with a part of the electronic device not covered by the main body portion.

### [Advantageous Effects of Invention]

An embodiment of the present disclosure makes it possible to achieve continuous external communication, even if a communication function of an electronic device is restricted.

### [Brief Description of Drawings]

[Fig. 1] is a diagram in which a front face side of an aerosol generating device is viewed from diagonally above.
[Fig. 2] is a diagram in which the front face side of the aerosol generating device is viewed from diagonally below.
[Fig. 3] is a diagram in which the aerosol generating device from which a shutter has been removed is viewed from above.
[Fig. 4] is a diagram in which a main body device with a front panel removed is viewed from a front face.
[Fig. 5] is a view of a rear face of the front panel removed from the main body device.
[Fig. 6] is a diagram schematically showing an internal configuration of an aerosol generating device used in embodiment 1.
[Fig. 7] is a diagram schematically showing connection relationships in a power source system circuit in the aerosol generating device used in embodiment 1.
[Fig. 8] is a flowchart illustrating an example of a front panel attachment detection operation implemented by a control unit in the main body device.
[Fig. 9] is a diagram illustrating an example in which the front panel is used as an upload proxy in the main body device.
[Fig. 10] is a diagram illustrating proxy reception by the front panel of a push delivery from a server to the main body device.
[Fig. 11] is a diagram schematically showing an internal configuration of an aerosol generating device used in embodiment 2.
[Fig. 12] is a diagram schematically showing connection relationships in a power source system circuit in the aerosol generating device used in embodiment 2.
[Fig. 13] is a flowchart illustrating an example of a USB charging operation implemented by the control unit of embodiment 2.
[Fig. 14] is a diagram illustrating the USB charging operation.

### [Description of Embodiments]

Embodiments relating to the present disclosure will be described below with reference to the drawings. In the drawings, identical parts are indicated by identical reference signs.

### <Terms>

An aerosol generating device according to each embodiment is a form of electronic cigarette.

In the following description, a substance generated by the aerosol generating device will be referred to as an aerosol. An aerosol refers to a mixture of minute liquid or solid particles suspended in a gas, and air or another gas.

The embodiments describe aerosol generating devices which generate the aerosol without associated burning.

In the following description, the action of a user inhaling the aerosol generated by the aerosol generating device will be referred to as "inhalation" or "a puff".

The embodiments describe aerosol generating devices to which a solid aerosol source can be fitted. It should be noted that a container for accommodating the solid aerosol source will be referred to as both a "capsule" and a "stick-type substrate", depending on the form of product. Capsules and stick-type substrates are consumables. Capsules and stick-type substrates therefore have fixed criteria for replacement.

### <Embodiment 1>

### <Example of External Appearance>

An example of the external appearance of an aerosol generating device 1 used in embodiment 1 will be described first of all.

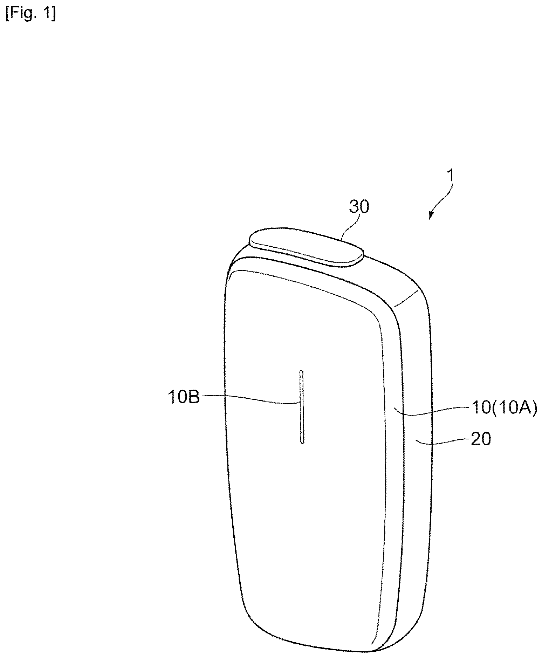

Fig. 1 is a diagram in which a front face side of the aerosol generating device 1 is viewed from diagonally above.

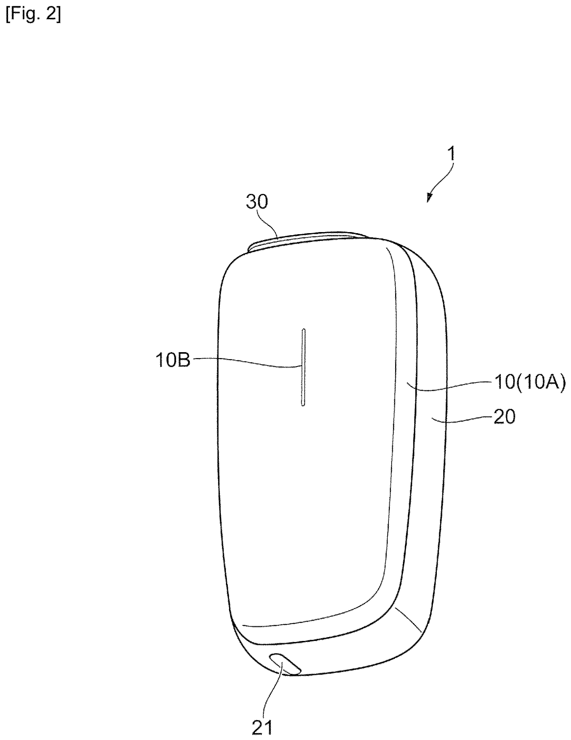

Fig. 2 is a diagram in which the front face side of the aerosol generating device 1 is viewed from diagonally below.

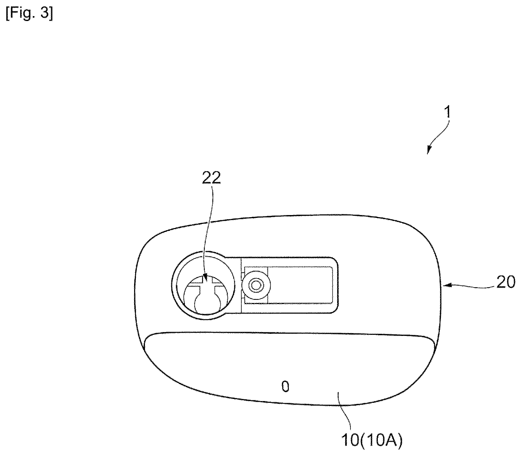

Fig. 3 is a diagram in which the aerosol generating device 1 from which a shutter 30 has been removed is viewed from above.

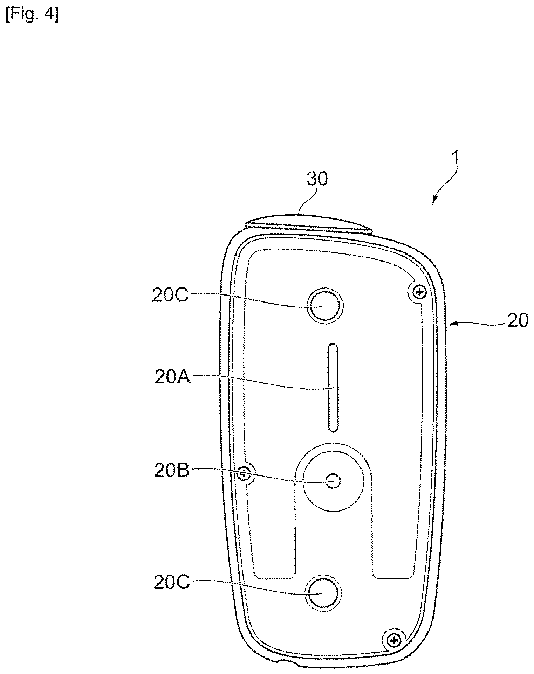

Fig. 4 is a diagram in which a main body device 20 with a front panel 10 removed is viewed from a front face.

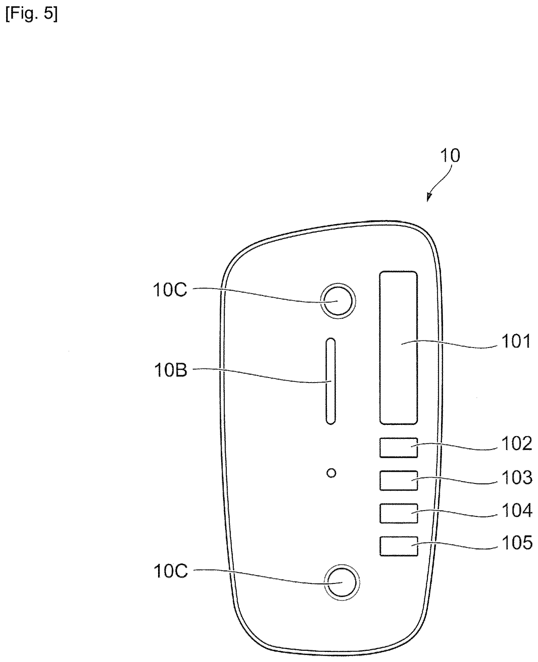

Fig. 5 is a view of a rear face of the front panel 10 removed from the main body device 20.

The aerosol generating device 1 used in this embodiment has a size such that a user can hold it in one hand.

The aerosol generating device 1 comprises: a main body device 20; a front panel 10 attached to a front face of the main body device 20; and a shutter 30 which is disposed on an upper face of the main body device 20 and can be slidably operated along the upper face. The main body device 20 referred to here is an example of a device main body.

The front panel 10 is a member which is detachable from the main body device 20. The front panel 10 referred to here is an example of a cover member. It should be noted that the front panel 10 is attached/detached by a user.

The front panel 10 attached to the main body device 20 covers a front face part of the main body device 20, as shown in fig. 1 and 2. In other words, parts of the main body device 20 other than the front face part can also be seen from the outside after the front panel 10 has been attached. Side faces, a back face, an upper face and a bottom face of the main body device 20 can also be seen from the outside after the front panel 10 has been attached, for example.

The front panel 10 attached to the main body device 20 joins continuously and steplessly with the side faces, upper face and bottom face of the main body device 20, as shown in fig. 1 and 2, forming an integral external appearance.

One role of the front panel 10 is thus decorative. Moreover, the side faces, upper face and bottom face of the main body device 20 are examples of parts which are not covered by the front panel 10.

The front panel 10 is provided with a window 10B. The window 10B is provided at a position facing a light-emitting element on the main body device 20 side. An LED (= light-emitting diode) 20A (see fig. 4) is used as the light-emitting element in embodiment 1.

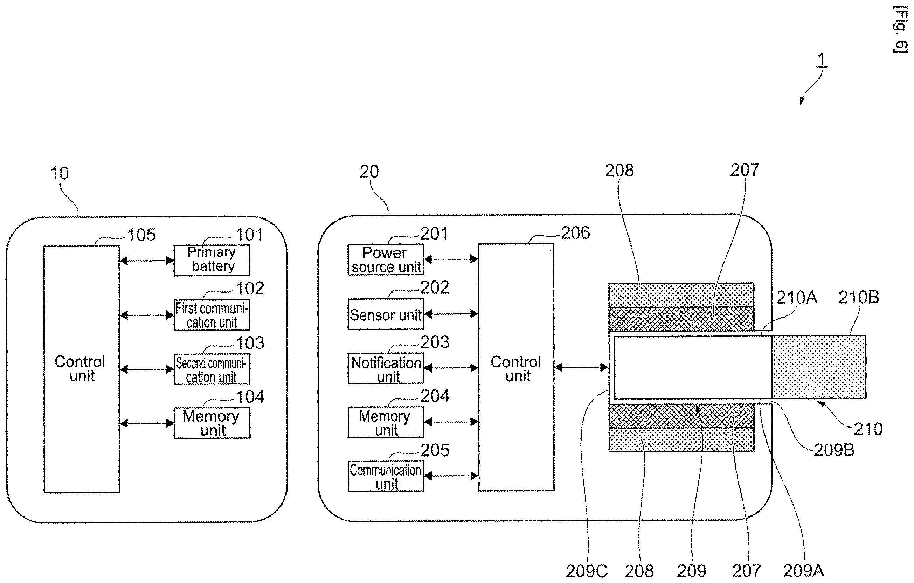

The window 10B of embodiment 1 is formed by a light-transmissive material. The window 10B may equally be a slit penetrating from a front surface to a rear surface. Moreover, illumination and flashing of the light-emitting element represent states of operation, etc. of the aerosol generating device 1. The states of operation also include errors. Illumination and flashing of the light-emitting element are controlled by a control unit 206 (see fig. 6) which will be described later.

In addition to its decorative role, the front panel 10 also has the role of alleviating propagation of heat released from the main body device 20, etc. In this embodiment, aerosol generation is therefore permitted only when the front panel 10 is attached to the main body device 20. In other words, the front panel 10 attached to the main body device 20 forms an integral external appearance with the main body device 20 in a state in which an aerosol can be generated.

Furthermore, the front panel 10 has a role of protecting the main body device 20 from soiling and scratches, etc.

In addition, the front panel 10 deforms as a result of a user pressing a location thereon below the window 10B with the fingertips, and the front panel 10 is restored to its original shape when pressing is stopped.

A primary battery 101 is fitted to an inner side of the front panel 10 used in this embodiment. When the front panel 10 fitted with the primary battery 101 is attached to the main body device 20, an amount of power which can be used by the aerosol generating device 1 as a whole can be increased as compared to when the front panel 10 not fitted with the primary battery 101 is attached to the main body device 20. The primary battery 101 fitted to the front panel 10 is an example of a second battery. It should be noted that the battery fitted to the front panel 10 will be referred to below as a "sub-battery".

The primary battery 101 fitted to the front panel 10 is used as an auxiliary power source for supplying the power required for operation of electronic components (e.g., a first communication unit 102, second communication unit 103, memory unit 104, and control unit 105) provided on the front panel 10.

The primary battery 101 is detachable from a rear face of the front panel 10. In other words, if the primary battery 101 has no residual capacity or reduced residual capacity, it can be replaced with a new primary battery 101.

Moreover, a main body panel 10A forming the external appearance of the front panel 10 shown in fig. 1 and 2 is an example of a main body portion.

Film-type, coin-type and chip-type batteries, for example, are feasible as the primary battery 101. The primary battery 101 needs to be thin in all cases so as not to impede attachment of the front panel 10 to the main body device 20.

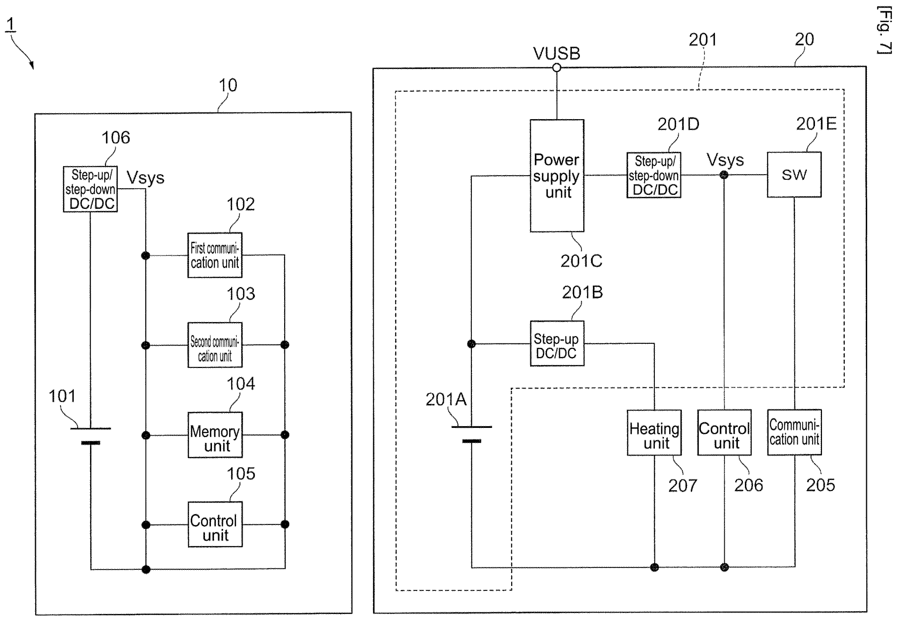

In this embodiment, a power system on the front panel 10 side is separate from a power system on the main body device 20 side. That is to say, power of the primary battery 101 provided on the front panel 10 is consumed in order to operate the electronic components provided on the main panel 10, and power of the secondary battery 201A (see fig. 7) provided in the main body device 20 is consumed in order to operate the electronic components provided in the main body device 20.

A type C USB (= universal serial bus) connector 21 is provided on the bottom face side of the main body device 20. The shape and type of USB connector 21 are given by way of example. In other words, the USB connector 21 may be a USB other than type C. In embodiment 1, the USB connector 21 is used for charging a power source unit 201 (see fig. 6) built into the main body device 20, for example.

A hole 22 for insertion of a stick-type substrate 210 (see fig. 6) accommodating an aerosol source is provided in an upper face portion of the main body device 20.

The stick-type substrate 210 used in this embodiment accommodates a solid aerosol source in a paper tube molded substantially into a cylindrical shape. The hole 22 is exposed by sliding the shutter 30 to an open position, and hidden by sliding the shutter 30 to a closed position.

The hole 22 has a cylindrical shape virtually the same as that of the stick-type substrate 210 in the case of embodiment 1. The diameter of an opening part of the hole 22 constitutes the dimension of a stick-type substrate 210 which can be inserted. In other words, the diameter of the stick-type substrate 210 is the dimension which can be inserted into the hole 22.

A magnet, for example, is attached to a rear face of the shutter 30. Meanwhile, a Hall IC is attached to the main body device 20 in a movable range of the shutter 30.

The Hall IC is a magnetic sensor formed by a Hall element and an operational amplifier, etc., and outputs a voltage commensurate with the intensity of the magnetic field passing across the Hall element.

In this embodiment, opening and closing of the shutter 30 is detected from a change in the voltage output from the Hall IC accompanying sliding of the shutter 30. That is to say, it is detected whether the shutter 30 is at the closed position or the open position.

A button 20B is disposed substantially in the center of the front face of the main body device 20. As indicated above, the button 20B is operable while the front panel 10 is in an attached state.

The button 20B is used, for example, for turning the power source of the main body device on and off, for turning the power supply to a heating unit 207 (see fig. 6) for heating the aerosol source on and off, and for Bluetooth (registered trademark) pairing commands, etc.

Moreover, a reset function is performed by a long press (e.g., pressing for 5 seconds or more) of the button 20B while the front panel 10 is removed from the main body device 20.

BLE (= Bluetooth low energy) is used as Bluetooth in this embodiment.

Magnets 20C used for attaching the front panel 10 are disposed on the upper portion and lower portion of the front face of the main body device 20. The magnets 20C are provided at positions facing magnets 10C provided on the inner side of the front panel 10. The magnets 10C on the front panel 10 are N poles, and the magnets 20C on the main body device 20 side are S poles, for example. The front panel 10 is detachably attached to the main body device 20 by the force of attraction of the magnets.

It should be noted that either the magnets 10C or the magnets 20C may be metal pieces made of iron or another magnetic metal. Incidentally, attachment of the front panel 10 to the main body device 20 is detected by means of the Hall IC provided on the main body device 20 side.

Various other types of electronic components required for generating an aerosol are built into the main body device 20. In this sense, the main body device 20 is an example of an electronic device specifically for generating an aerosol. Moreover, in a narrow sense the main body device 20 is referred to as an aerosol generating device.

### <Internal Configuration>

### <Configuration of Functional Unit>

Fig. 6 is a diagram schematically showing an internal configuration of the aerosol generating device 1 used in embodiment 1. It should be noted that fig. 6 shows a state in which the stick-type substrate 210 is fitted to the main body device 20. The user inhales the aerosol while the stick-type substrate 210 is held in the holding portion 209.

Furthermore, the internal configuration shown in fig. 6 is intended to illustrate the electronic components provided in the main body device 20 and positional relationships thereof. For this reason, the external appearance of the electronic components, etc. shown in fig. 6 does not always match the external appearance diagrams described above.

The primary battery 101, first communication unit 102, second communication unit 103, memory unit 104, and control unit 105 are provided on the front panel 10.

The first communication unit 102 is an electronic component for realizing communication with a terminal (referred to below as an "external terminal") other than the main body device 20.

Examples of external terminals which are feasible in this embodiment include: a smartphone or tablet-type terminal, or other information terminal carried by the user; a server of a company involved in the sale, etc. of front panels 10 and/or main body devices 20; and a server of a company involved in the sale, etc. of stick-type substrates 210 (see fig. 6).

In this embodiment, the first communication unit 102 uses Wi-Fi (registered trademark), a mobile communication system (4G, 5G), or Bluetooth (registered trademark), for example.

The second communication unit 103 is an electronic component for realizing communication with the main body device 20.

The second communication unit 103 uses a wireless communication module or a wired communication module.

Wireless communication modules include modules compatible with Bluetooth (registered trademark) or NFC (= near field communication), for example. Moreover, the second communication unit 103 may employ a module compatible with optical communication (photodiode and photodetector).

Wired communication modules include modules compatible with serial communication on a communication line.

The memory unit 104 is an electronic component used for storing information acquired from the main body device 20 and information acquired from the external terminal (e.g., a server). Specifically, the memory unit 104 is a semiconductor memory. The memory unit 104 may be a volatile semiconductor memory or may be a non-volatile semiconductor memory.

The information referred to here includes, for example, an inhalation log, a biosensor measurement log (e.g., heart rate, pulse, blood oxygen saturation, blood flow), residual power in the secondary battery 201A (see fig. 7), error information (overheating, overcurrent, overcharging, overdischarge, etc. of the secondary battery 201A), and location information detected by GPS (= global positioning system). It should be noted that these are examples of information, and not all of the information illustrated needs to be stored in the memory unit 104. Furthermore, information as referred to here may be other information.

Other information which may be stored in the memory unit 204 includes an operating system (= OS) and firmware (= FW), and other programs, for example.

The control unit 105 is an electronic component for controlling communication of the first communication unit 102 and the second communication unit 103 through execution of a program. The control unit 105 is realized by means of an electronic circuit such as a central processing unit (= CPU), a microprocessing unit (= MPU), a graphical processing unit (= GPU), an application-specific integrated circuit (= ASIC), a field programmable gate array (= FPGA), or a digital signal processor (= DSP), for example.

The control unit 206 may also include a read only memory (= ROM) for storing programs and computation parameters, etc., and a random access memory (= RAM) for temporarily storing suitably changing parameters, etc.

As well as acquiring the abovementioned information from the main body device 20, the control unit 105 also detects a state of operation of the main body device 20 through communication with the main body device 20 via the second communication unit 103.

For the information acquired from the main body device 20, information as to whether or not uploading to the external terminal is complete is also acquired from the main body device 20. In this embodiment, the control unit 105 stores, in the memory unit 104, information which has not yet been uploaded to the external terminal. That is to say, the control unit 105 deletes uploaded information from the memory unit 104.

Furthermore, the control unit 105 detects, as a state of operation of the main body device 20, whether or not electricity is currently being supplied to the heating unit 207 (i.e., whether or not a step-up DC/DC circuit 201B (see fig. 7) is currently operating).

In the main body device 20 of this embodiment, communication with the external terminal by means of the communication unit 205 is stopped while electricity is being supplied to the heating unit 207, so that a maximum supply power of the secondary battery 201A is not exceeded. A state in which a communication function is restricted is therefore subject to detection as a state of operation of the main body device 20 in this embodiment.

In addition, the control unit 105 communicates with the external terminal through the first communication unit 102. Communication as referred to here includes not only uploading information to the external terminal, but also receiving information push-delivered from the external terminal.

In this embodiment, communication between the control unit 105 provided on the front panel 10 and the external terminal may be implemented regardless of the state of operation of the main body device 20.

The main body device 20 is provided with: a power source unit 201, a sensor unit 202, a notification unit 203, a memory unit 204, a communication unit 205, a control unit 206, a heating unit 207, a heat insulating portion 208, and a holding portion 209. The power source unit 201 is a unit for supplying power to the main body device 20.

The sensor unit 202 is an electronic component for detecting various types of information relating to the main body device 20. The sensor unit 202 has a pressure sensor such as a microphone capacitor, or a flow rate sensor, for example. The sensor unit 202 serving as a sensor outputs detected information to the control unit 206. For example, when a change in air pressure or a flow of air accompanying inhalation has been detected, the sensor unit 202 outputs a numerical value representing inhalation by the user to the control unit 206.

The sensor unit 202 has an input device for receiving user input, for example. The input device is a button or a switch, for example. In this embodiment, the button 20B (see fig. 4) is used as the input device.

The button 20B is used for switching a main power source on and off, and for switching starting and stopping of electrical supply to the heating unit 207 (i.e., starting and stopping of aerosol generation), etc.

The content of user commands is output from the sensor unit 202 to the control unit 206. It should be noted that the button 20B is not only an example of a button but also an example of a switch.

The sensor unit 202 additionally has a temperature sensor for detecting the temperature of the heating unit 207. The temperature sensor detects the temperature of the heating unit 207 on the basis of an electrical resistance value of a conductive track of the heating unit 207, for example. The detected electrical resistance value is output from the sensor unit 202 to the control unit 206. It should be noted that the control unit 206 calculates the temperature of the heating unit 207 on the basis of the electrical resistance value. In other words, the control unit 206 calculates the temperature of the stick-type substrate 210 which is held in the holding portion 209.

The sensor unit 202 additionally has a sensor for detecting whether or not a sub-battery is fitted to the front panel 10 attached to the front face of the main body device 20 (i.e., whether or not a front panel 10 fitted with a sub-battery is attached).

For example, when a predetermined structural feature is detected from the attached front panel 10 via the sensor unit 202, the attached front panel 10 is deemed to be a front panel 10 fitted with a sub-battery. Furthermore, when a current or voltage is detected in the power source line used to supply electricity from the front panel 10, the attached front panel 10 is deemed to be a front panel 10 fitted with a sub-battery.

The sensor unit 202 additionally has a capacitive sensor, an optical sensor or a pressure sensor, etc. for detecting insertion of the stick-type substrate 210 into the holding portion 209, and proximity of objects, etc. through a change in electrostatic capacitance.

The sensor unit 202 furthermore has an optical color sensor for distinguishing individual stick-type substrates 210 by color, a radio-frequency identification (= RFID) reader, or an NFC (near field communication) reader, etc.

The sensor unit 202 furthermore has a biosensor for measuring the user's heart rate, etc., and a fingerprint sensor used for unlocking, etc.

The sensor unit 202 furthermore has an acceleration sensor or a gyro sensor, etc. for detecting movement of the user.

The notification unit 203 is an electronic component for notifying the user of various types of information relating to the main body device 20. The notification unit 203 comprises the LED 20A (see fig. 4) or another light-emitting device. For example, when the power source unit 201 needs to be charged, when the power source unit 201 is in the process of being charged, or when there is an abnormality in the main body device 20, the LED 20A emits light with different patterns for each.

The patterns as referred to here include different colors and different timings for illumination/extinguishing, etc.

Instead of or as well as the abovementioned light-emitting device, the notification unit 203 may also be configured by a display device for displaying images, a sound output device for outputting sounds, or a vibration device for causing the main body device 20 to vibrate, etc. The light-emitting device, display device, sound output device and vibration device, etc. are also examples of notification units for notifying information.

The notification unit 203 may additionally notify the user of a state in which the aerosol can be inhaled. This notification is made when the temperature of the stick-type substrate 210 heated by means of the heating unit 207 has reached a predetermined temperature.

The memory unit 204 is an electronic component for storing various types of information relating to operation of the main body device 20. The memory unit 204 is configured by a non-volatile semiconductor memory such as a flash memory, for example.

Information stored in the memory unit 204 includes an operating system (= OS) and firmware (= FW), and other programs, for example. The memory unit 204 furthermore stores a heating profile used for heating of the stick-type substrate 210 constituting the aerosol source. The heating profile is a data file stipulating temporal changes in a target temperature after the start of heating.

The memory unit 204 stores one heating profile in this embodiment.

It should be noted that the heating profile will be referred to as both a "control profile" and a "control sequence".

The information stored in the memory unit 204 additionally includes information relating to control of electronic components, for example. The information relating to control includes information relating to inhalation by the user, such as number of inhalations, times of inhalation, and cumulative inhalation time. In other words, the memory unit 204 stores a user inhalation behavior history and an operating history. These are examples of information constituting the inhalation log.

The communication unit 205 is an electronic component for realizing communication with the external terminal (including the front panel 10). The communication unit 205 uses a wireless communication module or a wired communication module.

The communication unit 205 of this embodiment employs, as a wireless communication module, a module compatible with Wi-Fi (registered trademark), a mobile communication system (4G, 5G), Bluetooth (registered trademark), or NFC, for example.

Furthermore, the communication unit 205 may employ an optical communication module. Additionally, the communication unit 205 employs, as a wired communication module, a communication module compatible with serial communication, for example.

The communication unit 205 of this embodiment is used not only for uploading the inhalation log and other information to the external terminal, but also for receiving various types of information push-delivered from the external terminal.

The control unit 206 is an electronic component which functions as an arithmetic processing device and a control device, and controls operations of the main body device 20 in accordance with various programs.

Control signals are sent through signal lines different from the power source line. For example, communication in the main body device 20 employs a serial communication method such as an inter-integrated circuit (= I2C) communication method, a serial peripheral interface (= SPI) communication method, or a universal asynchronous receiver transmitter (= UART).

The control unit 206 is realized by means of an electronic circuit such as a CPU, MPU, GPU, ASIC, FPGA, or DSP, etc., for example.

The control unit 206 may also include a ROM for storing programs and computation parameters, etc., and a RAM for temporarily storing suitably changing parameters, etc.

The control unit 206 executes various types of processing and control through execution of programs.

The processing and control referred to here include, for example: rewriting of heating profiles; supply of electricity from the power source unit 201 to other electronic components; charging of the power source unit 201; detection of information by the sensor unit 202; notification of information by the notification unit 203; storage and reading of information by the memory unit 204; and sending/receiving of information by the communication unit 205.

The control unit 206 additionally also controls switching of power sources to electronic components, etc.

Furthermore, the control unit 206 also has a function for judging whether or not the front panel 10 attached to the main body device 20 is a front panel 10 fitted with a sub-battery, etc., and for implementing processing and control correspondingly with a result of the judgment.

The holding portion 209 is a substantially cylindrical container. In this embodiment, a space inside the holding portion 209 defined by an inner wall and a bottom face will be referred to as an internal space 209A. The internal space 209A is substantially columnar.

An opening 209B allowing the internal space 209A to communicate with the exterior is provided in the holding portion 209. The stick-type substrate 210 is inserted into the internal space 209A from the opening 209B. The stick-type substrate 210 is inserted until a tip end thereof touches a bottom portion 209C.

The stick-type substrate 210 is only partially accommodated in the internal space 209A. A state in which the stick-type substrate 210 is accommodated in the internal space 209A will be referred to as the stick-type substrate 210 being held in the internal space 209A.

The inner diameter of at least part of the holding portion 209 in an axial direction thereof is formed so as to be smaller than the outer diameter of the stick-type substrate 210.

An outer circumferential surface of the stick-type substrate 210 inserted into the internal space 209A is therefore subjected to pressure from the inner wall of the holding portion 209. The stick-type substrate 210 is held in the internal space 209A by means of this pressure.

The holding portion 209 also has a function for defining a flow path for air passing through the stick-type substrate 210. An air inflow hole which is an inlet for air into the flow path is disposed in the bottom portion 209C, for example. Moreover, the opening 209B serves as an air outflow hole which is an outlet for the air.

In this embodiment, only part of the stick-type substrate 210 is held in the holding portion 209, with the remainder protruding outside from an enclosure. The part which is held in the holding portion 209 will be referred to below as a substrate portion 210A, and the part protruding from the enclosure will be referred to below as a mouthpiece portion 210B.

The aerosol source is accommodated in at least the substrate portion 210A. The aerosol source is a substance which is atomized by heating so as to generate an aerosol.

Other than shredded tobacco, the aerosol source contains a processed product obtained by molding a tobacco raw material into a granular form, a sheet form or a powder form, or another tobacco-derived substance.

In addition, the aerosol source may also contain a non-tobacco-derived substance produced from a plant other than tobacco, such as mint or herb. The aerosol source may contain a flavoring component such as menthol, for example.

When the main body device 20 is a medical inhaler, the aerosol source may contain a drug to be inhaled by a patient. It should be noted that the aerosol source is not limited to a solid, and may equally be a polyhydric alcohol such as glycerol or propylene glycol, or may be a liquid such as water, for example.

At least part of the mouthpiece portion 210B is held in the user's mouth during inhalation.

When the user inhales with the mouthpiece portion 210B held in the mouth, air flows into the internal space 209A from the air inflow hole. The air which has flowed in reaches the user's mouth after passing through the internal space 209A and the substrate portion 210A. The air reaching the user's mouth contains the aerosol generated by the substrate portion 210A.

The heating unit 207 is an electronic component formed by a heater or other heat-generating element. The heating unit 207 is formed by any material such as a metal or polyimide. The heating unit 207 is constructed in the form of a film, for example, and fitted to the outer circumferential surface of the holding portion 209.

The aerosol source contained in the stick-type substrate 210 is heated and atomized by the heat generated by the heating unit 207. The atomized aerosol source is mixed with air, etc., and an aerosol is generated.

In fig. 6, the outer circumferential region of the stick-type substrate 210 is initially heated, with the range of heating steadily moving toward the center.

Atomization of the aerosol source therefore starts from the outer circumferential region of the stick-type substrate 210 and steadily moves toward the center.

The heating unit 207 generates heat by means of electrical supply from the power source unit 201. Electrical supply to the heating unit 207 is permitted when predetermined user input is detected via the sensor unit 202, for example. The user input as referred to here includes operation of the shutter 30 (see fig. 1) and/or of the button 20B (see fig. 4). However, electricity is supplied to the heating unit 207 on the assumption that the front panel 10 (see fig. 1) is attached to the main body device 20. By attaching the front panel 10, the temperature transmitted to the user's hand can be reduced as compared to when the front panel 10 is not attached.

Moreover, inhalation by the user becomes possible when the temperature of the stick-type substrate 210 heated by means of the heating unit 207 reaches a predetermined temperature. Inhalation of the aerosol by the user is detected by means of the flow rate sensor, etc. in the sensor unit 202 and saved in the memory unit 204.

Electrical supply to the heating unit 207 is stopped when predetermined user input is subsequently detected by the sensor unit 202. It should be noted that it is also possible to adopt a method in which electricity is supplied to the heating unit 207 during a period in which inhalation by the user is detected by the sensor unit 202, and electrical supply to the heating unit 207 is stopped when inhalation by the user is no longer detected by the sensor unit 202.

Furthermore, in the example of fig. 6, the heating unit 207 is disposed outside the stick-type substrate 210, but it is equally possible for the heating unit 207 to be a blade-like metal piece which is inserted into the stick-type substrate 210 for use, or for the heating unit 207 to be a metal piece built into the stick-type substrate 210. When a metal piece acting as the heating unit 207 is built into the stick-type substrate 210, an induction heating coil should be arranged around the holding portion 209. An induction heating coil is an example of an electronic component.

The heat insulating portion 208 is a member for reducing propagation of heat generated by the heating unit 207 to the surrounding area. The heat insulating portion 208 is therefore disposed so as to cover at least the outer circumferential surface of the heating unit 207.

For example, the heat insulating portion 208 is configured by a vacuum insulating material or an aerogel insulating material, etc. A vacuum insulating material is a heat insulating material in which a state of high vacuum is created by wrapping glass wool and silica (silicon powder), etc. in a resin film, for example, so that heat conduction by gas is as close as possible to zero.

### <Power Source System Circuit of Main Body Device>

Fig. 7 is a diagram schematically showing connection relationships in a power source system circuit in the aerosol generating device 1 used in embodiment 1. It should be noted that fig. 7 shows a state in which the primary battery 101 is fitted to the main body portion of the front panel 10.

The front panel 10 shown in fig. 7 is provided with a step-up/step-down DC/DC circuit 106. The step-up/step-down DC/DC circuit 106 is an electronic component for changing an output voltage of the primary battery 101 to e.g., 3.3 V (i.e., a "system power source Vsys") The step-up/step-down DC/DC circuit 106 is configured by a switching regulator, for example.

The system power source Vsys generated by the step-up/step-down DC/DC circuit 106 is supplied to the first communication unit 102, second communication unit 103, memory unit 104, and control unit 105 provided on the front panel 10.

An example of the internal configuration of the power source unit 201 is shown for the main body device 20 illustrated in fig. 7. Note that the sensor unit 202, notification unit 203, and memory unit 204 have been omitted from fig. 7. The sensor unit 202, etc. here is connected to a power source line supplied with the system power source Vsys, in the same way as the communication unit 205 and the control unit 206.

The power source unit 201 shown in fig. 7 is provided with a secondary battery 201A, step-up DC/DC circuit 201B, power supply unit 201C, step-up/step-down DC/DC circuit 201D, and power source switch 201E.

A lithium ion secondary battery or capacitor, for example, is used for the secondary battery 201A. The secondary battery 201A is a battery for storing the electrical power required for operation of the main body device 20. The secondary battery 201A is an example of the first battery.

The secondary battery 201A will also be referred to below as the "main battery". The secondary battery 201A is chargeable from an external power source. A mains power source or a mobile battery, for example, is feasible as an external power source in this embodiment.

The step-up DC/DC circuit 201B is a circuit for supplying a constant voltage (e.g., 5 V), regardless of the output voltage of the secondary battery 201A, to a power source line to which the heating unit 207 is connected. The step-up DC/DC circuit 201B is configured by a switching regulator, for example.

The power supply unit 201C is a circuit which is responsible for distribution of power to the power source line supplying the system power source Vsys, and for voltage conversion, etc. of power supplied from an external power source (e.g., a mains power source).

When an external power source is not connected, the power supply unit 201C outputs the output voltage of the secondary battery 201A to the step-up/step-down DC/DC circuit 201D. Meanwhile, when an external power source is connected, the power supply unit 201C steps down the external power source to 4.2 V and outputs this voltage to the secondary battery 201A and the step-up/step-down DC/DC circuit 201D.

It should be noted that the power supply unit 201C outputs, for example, a 5 V power source Vcc5 to a power source line (not depicted) to which the LED 20A (see fig. 4) is connected.

A USB cable is used for supplying electricity from a mains power source or a mobile battery, so a corresponding electrical supply terminal is denoted by VUSB in fig. 7.

The step-up/step-down DC/DC circuit 201D is a circuit for converting the voltage provided from the power supply unit 201C to a 3.3 V system power source Vsys. For example, when the output voltage of the secondary battery 201A is provided from the power supply unit 201C, the step-up/step-down DC/DC circuit 201D generates the 3.3 V system power source Vsys by stepping up or stepping down the output voltage. The output voltage of the secondary battery 201A fluctuates according to residual capacity and extent of deterioration, as is well known, but is converted to 3.3 V by means of the step-up/step-down DC/DC circuit 201D.

Meanwhile, when the output voltage of an external power source is provided from the power supply unit 201C, the step-up/step-down DC/DC circuit 201D generates the 3.3 V system power source Vsys by stepping down the output voltage. The step-up/step-down DC/DC circuit 201D is configured by a switching regulator, for example.

The power source switch 201E is a circuit for turning on/off supply of the system power source Vsys to the communication unit 205. The control unit 206 commands switching of the power source switch 201E.

A configuration in which the power source switch 201E shown in fig. 7 is not provided is equally possible. In that case, the system power source Vsys is then always supplied to the communication unit 205 also. If the communication unit 205 is not used for communication, the communication unit 205 is in a state of controlled communication, and the power consumed by the communication unit 205 can be ignored.

### <Processing Operation Example>

An example of processing operations implemented by the control unit 206 (see fig. 6) in the main body device 20 (see fig. 6) will be described below.

### <Attachment Detection Operation>

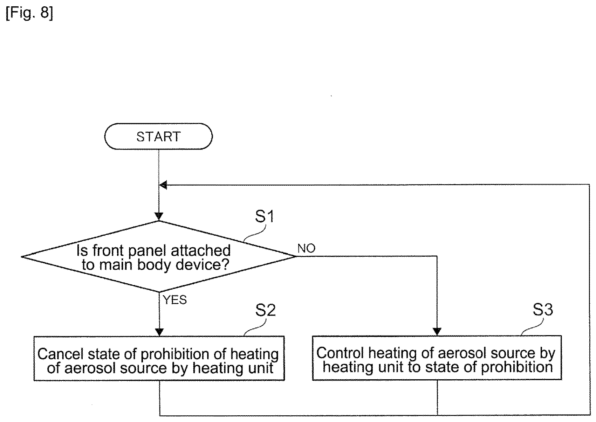

Fig. 8 is a flowchart illustrating an example of an operation to detect attachment of the front panel 10 which is implemented by the control unit 206 in the main body device 20. This operation is implemented not only before the start of heating by the heating unit 207 (see fig. 6), but also after heating has started, and is constantly implemented in the background. Note that the symbol "S" in the drawings means "step".

The control unit 206 first of all determines whether or not the front panel 10 (see fig. 1) is attached to the main body device 20 (see fig. 1) (step 1).

When the front panel 10 is attached to the main body device 20, an affirmative result is obtained in step 1. On the other hand, when the front panel 10 is removed from the front face of the main body device 20, a negative result is obtained in step 1. Attachment/detachment of the front panel 10 is determined on the basis of an output signal from the Hall IC.

When an affirmative result is obtained in step 1, the control unit 206 cancels the state of prohibition of heating of the aerosol source by the heating unit 207 (step 2).

However, canceling the state of prohibition of heating is different from heating being started. Heating of the stick-type substrate 210 (see fig. 6) constituting the aerosol source is started by a long press of 1 second or greater of the button 20B (see fig. 4) from above the front panel 10.

When a negative result is obtained in step 1, the control unit 206 controls heating of the aerosol source by the heating unit 207 to the state of prohibition (step 3). This makes it possible to prevent heating of the aerosol source while the front panel 10 is not attached.

When step 2 or step 3 is implemented, the control unit 206 repeatedly returns to step 1 to determine whether or not the front panel 10 is attached to the main body device 20.

This attachment detection operation ensures that the user is not directly touching the main body device 20 during a heating operation.

### <Front Panel Used as Upload Proxy>

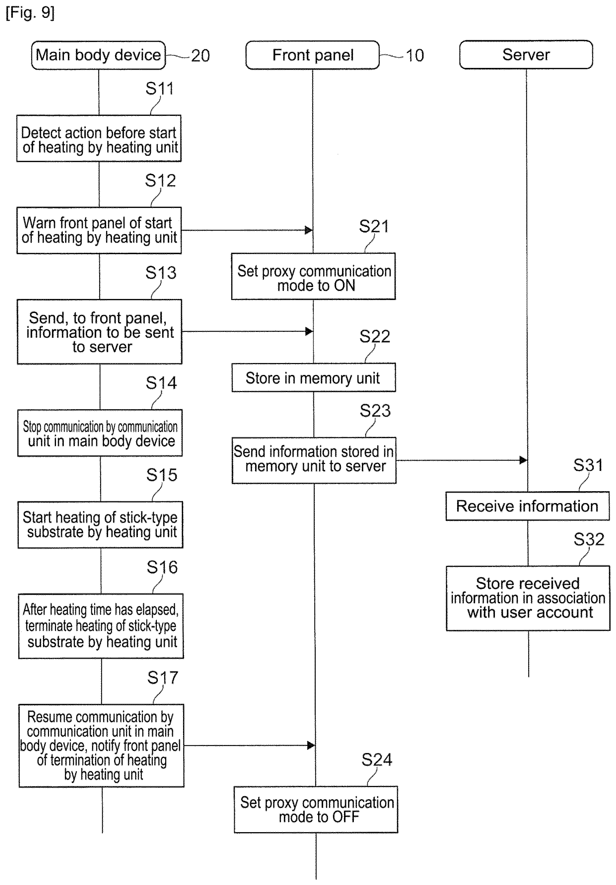

Fig. 9 is a diagram illustrating an example in which the front panel 10 is used as an upload proxy in the main body device 20. Among the processing operations illustrated in fig. 9, the processing operations of the front panel 10 are implemented by means of the control unit 105 (see fig. 6), and the processing operations of the main body device 20 are implemented by the control unit 206 (see fig. 6).

In this embodiment, when the control unit 206 in the main body device 20 detects an action before the start of heating by the heating unit 207 (step 11), the control unit 206 warns the front panel 10 of the start of heating by the heating unit 207 (step 12).

An action before the start of heating as referred to here includes, for example, detection of an operation to slide the shutter 30 to the open position, and detection of operation of the button 20B with the front panel 10 in an attached state, etc.

Incidentally, when the shutter 30 is slid to the open position, this produces a state in which the stick-type substrate 210 can be inserted into the hole 22. The shutter 30 is slid to the closed position when inhalation is not required, and sliding of the shutter 30 to the open position therefore corresponds to an action before the start of heating by the heating unit 207.

Furthermore, operation of the button 20B with the front panel 10 in an attached state corresponds to an initialization action before the start of heating by the heating unit 207.

It should be noted that the control unit 105 (see fig. 6) on the front panel 10 which has received the warning of the start of heating by the heating unit 207 from the main body device 20 sets a proxy communication mode to ON (step 21).

The control unit 206 in the main body device 20 then sends to the front panel 10 information to be sent to the server (step 13). "Information to be sent" as referred to here means information that has at least not been sent to the server. In other words, "information to be sent" means unsent information. This is because there is no need for information which has already been sent to be re-sent to the server. It should be noted that "sent" means that a receipt acknowledgement (ACK) has arrived from the server.

In this embodiment, the information to be sent includes, for example: the inhalation log, the biosensor measurement log, residual power in the secondary battery 201A, error information, and location information detected by GPS.

The front panel 10 having received the information to be sent stores the received information in the memory unit 104 (see fig. 6) (step 22).

The "information to be sent" may be limited to unsent information which is to be sent to the server within a few minutes from the current time. This is because, if the scheduled time of sending will mean arrival of the information after the end of aerosol inhalation, the relevant information can be sent to the server from the main body device 20.

After step 13 has been implemented, the control unit 206 stops communication by the communication unit 205 in the main body device 20 (step 14).

The time which can be allocated for the processing from steps 11 through 13 is limited. For this reason, if communication to the front panel 10 of information to be sent is started after an action to start heating by the heating unit 207 has been detected, it is possible that communication by the communication unit 205 in the main body device 20 will be stopped before the communication of information has ended.

As a measure against this, it is possible to adopt a procedure in which the information to be sent which was generated by the main body device 20 is sent to the front panel 10 simultaneously with generation thereof or periodically, regardless of detection of an action to start heating by the heating unit 207. When this procedure is adopted, however, information uploaded to the server from the main body device 20 is also held by the control unit 105 on the front panel 10, and that information is deleted from the memory unit 104, or duplicate uploads are prohibited.

It should be noted that, after step 14 has been implemented, the control unit 206 in the main body device 20 starts heating of the stick-type substrate 210 by means of the heating unit 207 (step 15). The heating temperature of the heating unit 207 is controlled in accordance with the heating profile.

After the heating time has elapsed, the control unit 206 in the main body device 20 terminates heating of the stick-type substrate 210 by means of the heating unit 207 (step 16).

After this, the control unit 206 in the main body device 20 resumes communication by the communication unit 205 in the main body device 20 and notifies the front panel 10 that heating by the heating unit 207 has been terminated (step 17).

Meanwhile, after step 22 has been implemented, the control unit 105 on the front panel 10 sends the information stored in the memory unit 104 to the server (step 23).

After this, on receipt of the notification of step 17, the control unit 105 on the front panel 10 sets the proxy communication mode to OFF (step 24). Setting of the proxy communication mode to OFF may equally be implemented by completion of the sending of information in step 23.

It should be noted that, when the server receives information from the front panel 10 (step 31), the server stores the received information in association with a user account (step 32).

It should be noted that the server implements the processing operation of step 32 for information received from the communication unit 205 in the main body device 20 during periods of no heating by the heating unit 207.

### <Proxy Reception of Push Delivery by the Front Panel>

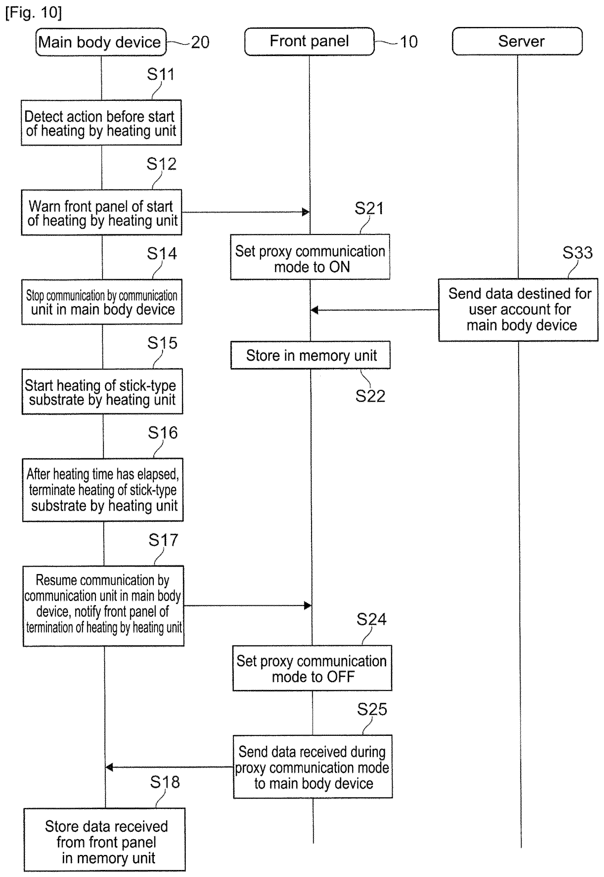

Fig. 10 is a diagram illustrating proxy reception by the front panel 10 of a push delivery from the server to the main body device 20. Corresponding reference signs are given in fig. 10 for parts which correspond to those of fig. 9.

The processing operations shown in fig. 10 are also started as a result of the control unit 206 in the main body device 20 detecting an action before the start of heating by the heating unit 207.

Next, when the control unit 206 in the main body device 20 warns the front panel of the start of heating by the heating unit 207 (step 12), the control unit 105 on the front panel 10 sets the proxy communication mode to ON (step 21). After this, the control unit 105 on the front panel 10 is in a state of acting as a proxy for communication between the server and the main body device 20.

Fig. 10 shows a case in which the proxy communication mode is set to ON, after which the server sends the data destined for the user account for the main body device 20 (step 33).

In fig. 10, this data can be received only by the front panel 10. This is because the communication unit 205 in the main body device 20 is stopped from communicating with the external terminal.

The control unit 105 on the front panel 10 therefore stores the received data in the memory unit 104 (step 22).

During this time, the control unit 206 in the main body device 20 implements steps 14-17 in order.

On receipt of the notification of step 17, the control unit 105 on the front panel 10 sets the proxy communication mode to OFF (step 24), and sends the data received during the proxy communication mode to the main body device 20 (step 25).

Meanwhile, the control unit 206 in the main body device 20 stores the data received from the front panel 10 in the memory unit 204 (step 18).

By means of this series of processing operations, the control unit 206 in the main body device 20 can still continuously communicate with the server via the front panel 10 during periods in which communication by the communication unit 205 is stopped.

Consequently, even if there is an overlap between heating periods of the heating unit 207, which occur irregularly, and the timing of push deliveries from the server, there is no need to wait for the push delivery from the server to be re-sent after the heating period of the heating unit 207 has ended.

Furthermore, it is also possible to suppress data reception failures when push deliveries are not re-sent.

### <Summary>

By attaching the front panel 10 described in this embodiment to the main body device 20, the first communication unit 102 on the front panel 10 can maintain communication between the main body device 20 and the server, even if the communication function of the communication unit 205 in the main body device 20 is stopped. For example, information to be sent can be uploaded to the server by the front panel 10 at the scheduled timing. Furthermore, for example, the front panel 10 can receive information push-delivered from the server instead of the main body device 20, and can reduce reception failures of information from the server.

### <Embodiment 2>

This embodiment describes a case in which the sub-battery fitted to the front panel 10 is a secondary battery.

The basic hardware configuration and functional configuration of this embodiment are therefore the same as in embodiment 1. However, the connection relationships in the power source system circuit of this embodiment are different from those of embodiment 1.

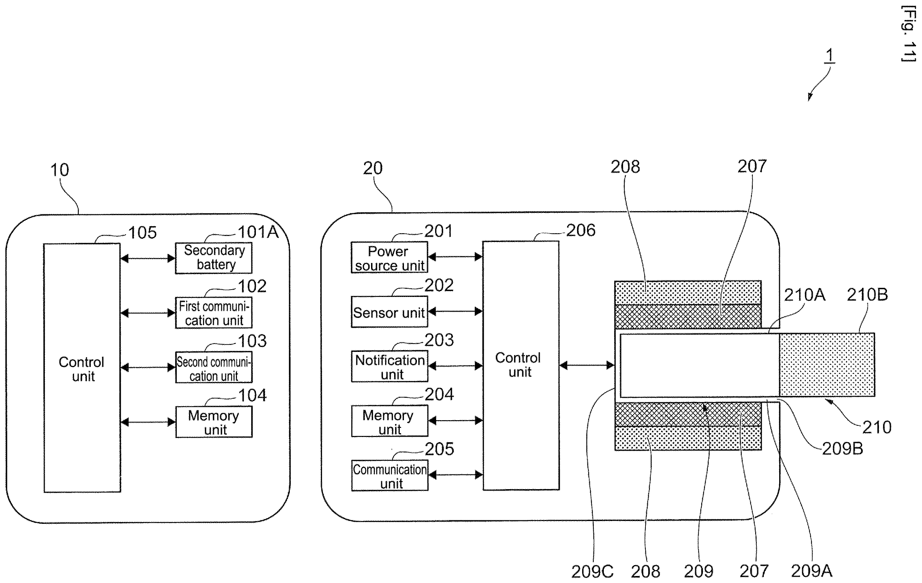

Fig. 11 is a diagram schematically showing the internal configuration of the aerosol generating device 1 used in embodiment 2. Corresponding reference signs are given in fig. 11 for parts which correspond to those of fig. 6.

The difference between fig. 11 and fig. 6 lies in the fact that the sub-battery fitted to the front panel 10 is a secondary battery 101A.

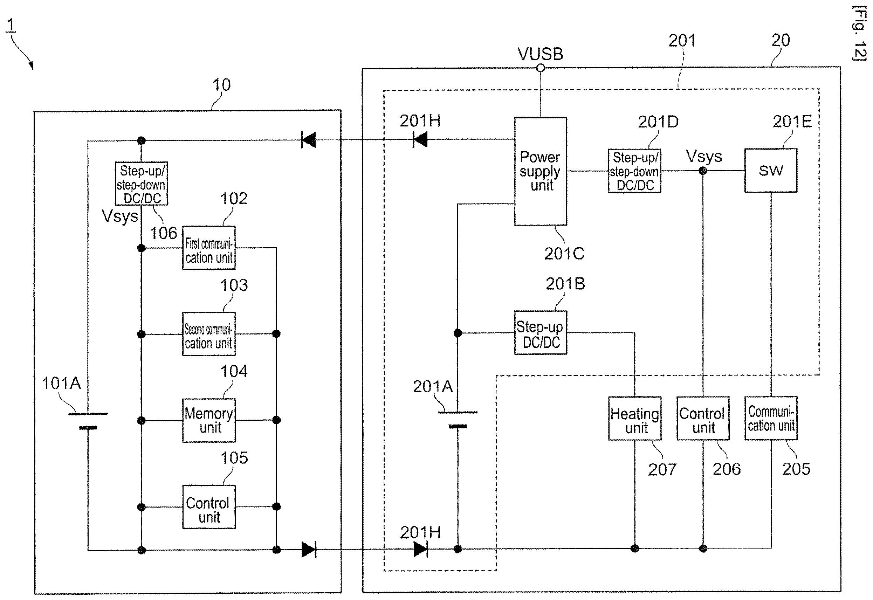

Fig. 12 is a diagram schematically showing connection relationships in a power source system circuit in the aerosol generating device 1 used in embodiment 2. Corresponding reference signs are given in fig. 12 for parts which correspond to those of fig. 7.

In fig. 12, a power source line for charging the secondary battery 101A on the front panel 10 is added to the power source unit 201 and a reverse current preventing circuit 201F. Charging of the secondary battery 101A on the front panel 10 is performed by the power supply unit 201C. Other components are the same as in the power source unit 201 illustrated in fig. 7.

The control unit 206 of this embodiment implements the same processing operations as described in embodiment 1.

A description will be given below of a processing operation specific to this embodiment, that is, an operation to charge the secondary battery 101A on the front panel 10.

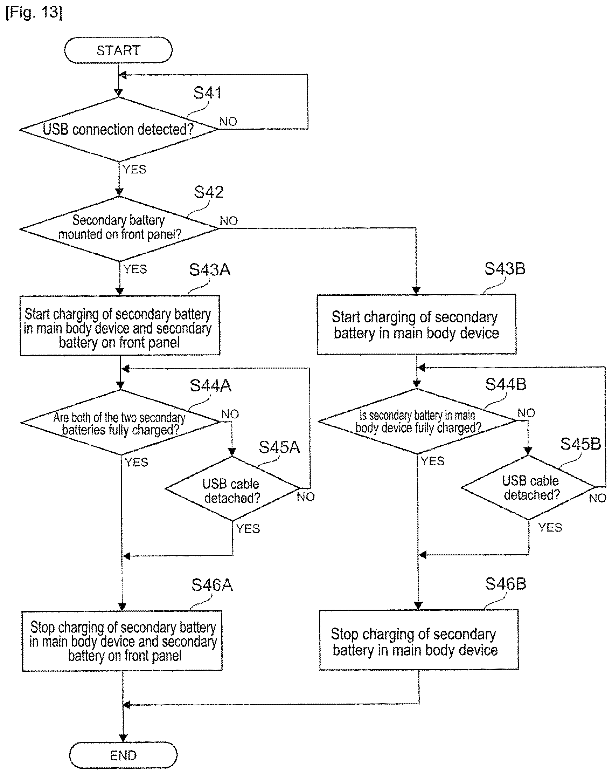

Fig. 13 is a flowchart illustrating an example of a USB charging operation implemented by the control unit 206 of embodiment 2.

The control unit 206 first of all determines whether or not a USB connection has been detected (step 41).

A negative result is obtained in step 41 when a USB connection is not detected. In this case the control unit 206 repeats the determination of step 41.

Meanwhile, an affirmative result is obtained in step 41 when a USB connection has been detected. In this case, the control unit 206 determines whether or not the secondary battery is mounted on the front panel 10 (step 42).

An affirmative result is obtained in step 42 when the secondary battery is mounted on the front panel 10. In this case, the control unit 206 starts charging of the secondary battery in the main body device 20 and of the secondary battery on the front panel 10 (step 43A). Note that the actual charging may employ a process in which either one of the secondary battery 201A in the main body device 20 and the secondary battery 101A on the front panel 10 is charged to full capacity first, then the other secondary battery is charged to full capacity. Charging of the secondary battery 201A in the main body device 20 and the secondary battery 101A on the front panel 10 may equally be performed in parallel.

The control unit 206 then determines whether or not both of the two secondary batteries are fully charged (step 44A).

A negative result is obtained in step 44A if either of the two secondary batteries is not fully charged. Meanwhile, an affirmative result is obtained in step 44A when both of the two secondary batteries are fully charged.

If a negative result is obtained in step 44A, the control unit 206 determines whether or not the USB cable has been detached (step 45A).

A negative result is obtained in step 45A if the USB cable is still attached. In this case, the control unit 206 returns to step 44A. Meanwhile, an affirmative result is obtained in step 45A if the USB cable has become detached during charging.

If an affirmative result is obtained in step 44A or if an affirmative result is obtained in step 45A, the control unit 206 stops charging of the secondary battery in the main body device 20 and of the secondary battery on the front panel 10 (step 46A).

After this, the control unit 206 terminates the USB charging operation.

The description will return to the determination in step 42.

A negative result is obtained in step 42 when the secondary battery 101A is not mounted on the front panel 10 (including not only a case in which the sub-battery is not mounted, but also a case in which the sub-battery which is mounted is the primary battery 101). In this case, the control unit 206 starts charging of the secondary battery 201A in the main body device 20 (step 43B).

The control unit 206 then determines whether or not the secondary battery 201A in the main body device 20 is fully charged (step 44B).

A negative result is obtained in step 44B if the secondary battery 201A is not fully charged. Meanwhile, an affirmative result is obtained in step 44B if the secondary battery 201A is fully charged.

If a negative result is obtained in step 44B, the control unit 206 determines whether or not the USB cable has been detached (step 45B).

A negative result is obtained in step 45B if the USB cable is still attached. In this case, the control unit 206 returns to step 44B. Meanwhile, an affirmative result is obtained in step 45B if the USB cable has become detached during charging.

If an affirmative result is obtained in step 44B or if an affirmative result is obtained in step 45B, the control unit 206 stops charging of the secondary battery in the main body device 20 (step 46B).

After this, the control unit 206 terminates the USB charging operation.

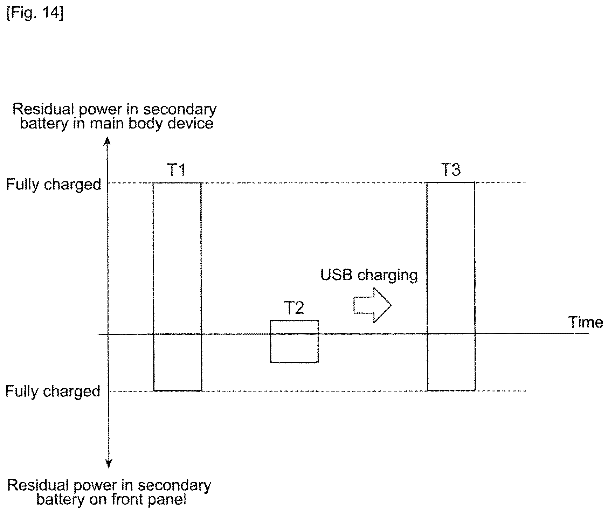

Fig. 14 is a diagram illustrating the USB charging operation.

The horizontal axis in the drawing denotes time, the top half of the vertical axis denotes residual power in the secondary battery 201A in the main body device 20, and the bottom half of the vertical axis denotes remaining power in the secondary battery 101A in the front panel 10.

In fig. 14, the secondary battery 101A on the front panel 10 and the secondary battery 201A in the main body device 20 are both fully charged in an initial state T1.

At a time point T2, the residual power in the secondary battery 101A on the front panel 10 and the secondary battery 201A in the main body device 20 has fallen below full charge in both cases. USB charging is started when the USB cable is connected in this state.

At T3 at the end of USB charging, the secondary battery 101A on the front panel 10 and the secondary battery 201A in the main body device 20 both return to fully charged.

### <Summary>

When the secondary battery 101A is provided on the front panel 10, the secondary battery 101A on the front panel 10 is also charged together during charging of the secondary battery 201A in the main body device 20. Consequently, there are no situations where a sub-battery has inadequate residual power during use of the main body device 20, unlike when the primary battery 101 is provided on the front panel 10.

### <Other Embodiments>

(1) Embodiments of the present disclosure were described above, but the technical scope of the present disclosure is not limited to the scope disclosed in the embodiments above. It will be obvious from the disclosure of the claims that the technical scope of the present disclosure also includes various modifications or improvements made to the embodiments above.
(2) The embodiments above described a case in which the junction between the front panel 10 and the main body device 20 forms a continuous and stepless joint with an integral external appearance, but the junction may also include a step or cutout, etc., provided that there is an integral external appearance with the main body device 20.
(3) The embodiments above described a case in which the aerosol source is a solid, but the aerosol source may equally be a liquid. When the aerosol source is a liquid, a system is adopted in which the aerosol source is guided to a narrow tube known as a wick by using a capillary phenomenon, and a coil wound around the wick is heated to thereby vaporize the aerosol source.
(4) The embodiments above described an aerosol generating device which generates an aerosol by heating a solid aerosol source, but the aerosol generating device may equally generate an aerosol by separately heating each of a solid aerosol source and a liquid aerosol source. An aerosol generating device of this type is also referred to as a hybrid aerosol generating device.
(5) The embodiments above employ a device configuration in which the primary battery 101 or the secondary battery 101A is provided on the front panel 10, but the system power source Vsys required for operation of the first communication unit 102, the second communication unit 103, the memory unit 104, and the control unit 105 provided on the front panel 10 may equally be supplied from the secondary battery 201A in the main body device 20.
   The supply of power referred to here may be electrical supply by means of a contact method or electrical supply by means of a contactless method. Standards for the contactless power supply referred to here include standards based on electromagnetic induction systems, such as the Qi standard and the NFC (= near field communication) standard, and electric field induction systems.
(6) The embodiments above described the aerosol generating device 1 (main body device 20) to which the front panel 10 is attached as an example of an electronic device, but the electronic device may equally be an electronic device which is usable in a state in which a cover member (including a main body cover or a protective cover) or a panel member is attached, the cover member or panel member being detachable from the device main body, and examples of such electronic devices include a remote control, a gaming device, a music player, a video camera, a digital camera, an electronic dictionary, and an electronic calculator.
   When communication is restricted, an economy mode or a power saving mode may be set for the purpose of reducing power consumption in the device main body, for example when communication by means of the device main body is set to airplane mode.
(7) In the embodiments above, power from the primary battery 101 (see fig. 6) and the secondary battery 101A (see fig. 11) provided on the front panel 10 is supplied only to the electronic components provided on the front panel 10 in both cases, but this power may equally be supplied to electronic components provided in the main body device 20.
(8) The embodiments above described an example in which aerosol generation is permitted when the front panel 10 is attached to the main body device 20, but aerosol generation by the main body device 20 may also be possible while the front panel 10 is not attached.
   In this case, attachment of the front panel 10 to the main body device 20 is used to broaden the functions that may be implemented by the main body device 20. For example, the main body device 20 with the front panel 10 removed communicates directly with the server or other external terminal, but a function for proxy communication using the first communication unit 102 of the front panel 10 is enabled after the front panel 10 has been attached.
(9) The embodiments above described a state in which aerosol generation is possible as an example of the aerosol generating device 1 (main body device 20) being in an operable state, but this is not limiting. For example, the aerosol generating device 1 (main body device 20) is in an operable state even if an aerosol cannot be generated due to a lack of power, provided that another function is operating. The other function as referred to here includes, for example, a function for checking and presenting residual power in the secondary battery 201A, etc., a function for acquiring and presenting an inhalation history, and a function for communicating with an external terminal.
(10) The embodiments above described an example in which the button 20B provided on the main body device 20 is operated by pressing the front panel 10 fitted to the main body device 20 to cause deformation, but input instructions to the main body device 20 may also employ a method other than deformation of the front panel 10.

For example, a touch panel may be provided on the front panel 10, and information indicating a user operation on the touch panel may be notified to the control unit 206 (see fig. 6) in the main body device 20 via the communication unit 104 (see fig. 6).

As a further example, a switch or button may be arranged on the front panel 10, and the presence or absence, etc. of an operation thereon may be notified to the control unit 206 (see fig. 5) in the main body device 20 via the communication unit 104 (see fig. 6). The touch panel and switch, etc. as referred to here are examples of an operating unit.

Moreover, a heat shielding structure is used on surface members and inside a main body device 20 of this type.

### <Summary>

It should be noted that the present disclosure includes the following features.
(1) A cover member which is detachable from an electronic device operated by means of a first battery is provided with: a first communication unit capable of communicating with an external terminal; a second communication unit for acquiring information relating to the electronic device from said electronic device; and a control unit for controlling communication of the first communication unit and the second communication unit on the basis of the information relating to the electronic device acquired through the second communication unit.
(2) The cover member as disclosed in (1), wherein, during a period in which communication between the electronic device and the external terminal is restricted, the first communication unit sends the information acquired from the electronic device to the external terminal.
(3) The cover member as disclosed in (2), wherein the period in which communication is restricted is a period in which power supplied by the first battery is close to an upper limit value.
(4) The cover member as disclosed in (2), wherein the first communication unit sends to the external terminal information indicating a state of operation of the electronic device.
(5) The cover member as disclosed in any one of (1) to (4), comprising a second battery which is charged by means of electrical supply from the electronic device during charging thereof.
(6) The cover member as disclosed in (2), wherein, when the electronic device is an aerosol generating device comprising a heating unit for heating an aerosol source, the first communication unit sends information previously acquired from the aerosol generating device to the external terminal while the aerosol source is being heated by means of the heating unit.
(7) The cover member as disclosed in any one of (1) to (6), wherein, when the electronic device is an aerosol generating device comprising a heating unit for heating an aerosol source, a main body portion covers part of the surface of the aerosol generating device.
(8) The cover member as disclosed in any one of (1) to (7), wherein, when the electronic device is an aerosol generating device comprising a heating unit for heating an aerosol source, attachment of a main body portion to the aerosol generating device constitutes one condition enabling heating of the aerosol source by means of the heating unit.
(9) The cover member as disclosed in any one of (1) to (8), wherein a switch on the electronic device side is operable as a result of pressing by a user while a main body portion is attached to the electronic device.
(10) The cover member as disclosed in any one of (1) to (8), further comprising an operation unit for receiving user operations and notifying same to the electronic device.
(11) The cover member as disclosed in any one of (1) to (9), wherein a main body portion attached to the electronic device forms an integral external appearance with a part of the electronic device not covered by the main body portion.

### [Reference Signs List]

1... Aerosol generating device; 10... Front panel; 10A... Main body panel; 10B... Window; 10C, 20C... Magnet; 20... Main body device; 20A... LED; 20B... Button; 21... USB connector; 22... Hole; 30... Shutter; 101... Primary battery; 101A, 201A... Secondary battery; 102... First communication unit; 103... Second communication unit; 104, 204... Memory unit; 201... Power source unit; 202... Sensor unit; 203... Notification unit; 205... Communication unit; 206... Control unit; 207... Heating unit; 208... Heat insulating portion; 209... Holding portion; 210... Stick-type substrate

## Claims

1. A cover member which is detachable from an electronic device operated by means of a first battery, the cover member comprising:
a first communication unit capable of communicating with an external terminal;
a second communication unit for acquiring information relating to the electronic device from said electronic device, and
a control unit for controlling communication of the first communication unit and the second communication unit on the basis of the information relating to the electronic device acquired through the second communication unit.

2. The cover member as claimed in claim 1, wherein, during a period in which communication between the electronic device and the external terminal is restricted, the first communication unit sends the information acquired from the electronic device to the external terminal.

3. The cover member as claimed in claim 2, wherein the period in which communication is restricted is a period in which power supplied by the first battery is close to an upper limit value.

4. The cover member as claimed in claim 2, wherein the first communication unit sends to the external terminal information indicating a state of operation of the electronic device.

5. The cover member as claimed in any one of claims 1 to 4, comprising a second battery which is charged by means of electrical supply from the electronic device during charging thereof.

6. The cover member as claimed in claim 2, wherein, when the electronic device is an aerosol generating device comprising a heating unit for heating an aerosol source,
the first communication unit sends information previously acquired from the aerosol generating device to the external terminal while the aerosol source is being heated by means of the heating unit.

7. The cover member as claimed in any one of claims 1 to 6, wherein, when the electronic device is an aerosol generating device comprising a heating unit for heating an aerosol source,
a main body portion covers part of the surface of the aerosol generating device.

8. The cover member as claimed in any one of claims 1 to 7, wherein, when the electronic device is an aerosol generating device comprising a heating unit for heating an aerosol source,
attachment of a main body portion to the aerosol generating device constitutes one condition enabling heating of the aerosol source by means of the heating unit.

9. The cover member as claimed in any one of claims 1 to 8, wherein a switch on the electronic device side is operable as a result of pressing by a user while a main body portion is attached to the electronic device.

10. The cover member as claimed in any one of claims 1 to 8, further comprising an operation unit for receiving user operations and notifying same to the electronic device.

11. The cover member as claimed in any one of claims 1 to 9, wherein a main body portion attached to the electronic device forms an integral external appearance with a part of the electronic device not covered by the main body portion.
